# EUROPEAN PATENT SPECIFICATION

(11) **EP 1 206 777 B1**
(45) Date of publication and mention of the grant of the patent: **08.08.2007**
(21) Application number: 00952732.6
(22) Date of filing: 11.08.2000
(51) Int. Cl.: G11C 15/00, G11C 15/04

(54) **MATCH RESOLUTION CIRCUIT FOR AN ASSOCIATIVE MEMORY**
VERGLEICHAUFLÖSESCHALTUNG FUR INHALTSADRESSIERBAREN SPEICHER
CIRCUIT DE RESOLUTION DE CORRESPONDANCE POUR MEMOIRE ASSOCIATIVE

(30) Priority: 11.08.1999 US 148403 P
(43) Date of publication of application: 22.05.2002
(73) Proprietor: INTEL CORPORATION, Santa Clara, CA 95202 (US)
(72) Inventor: HENDERSON, Alex, E., Hillsborough, CA 94010 (US); CROFT, Walter, E., San Mateo, CA 94402 (US); Chu, Raymond, (US); Sarin, Vishal, (US)
(74) Representative: McLeish, Nicholas Alistair Maxwell
(86) International application number: PCT/US2000/022002
(87) International publication number: WO 2001/011630

(56) References cited:
- EP-A- 0 622 805
- JP-A- 11 102 589
- NL-C- 1 011 523
- SU-A- 670 932
- US-A- 4 897 814
- US-A- 5 555 397
- "MEMORY ORGANIZATION SCHEME FOR THE IMPLEMENTATION OF ROUTING TABLES IN HIGH PERFORMANCE IP ROUTERS" IBM TECHNICAL DISCLOSURE BULLETIN,US,IBM CORP. NEW YORK, vol. 36, no. 2, 1 February 1993 (1993-02-01), pages 151-153, XP000354291 ISSN: 0018-8689

## Description

### RELATED APPLICATION

The subject matter of the present application is related to and claims priority from U.S. provisional patent application serial no. 60/148,403, entitled "Match Resolution Circuit for Content Addressable Memory " by Alex E. Henderson and Walter E. Croft, which application was filed on August 11, 1999.

### BACKGROUND

### A. Technical Field

The present invention relates generally to associative memories, and in particular to content addressable memories. More particularly, the present invention relates to an associative memory having a match resolution circuit for determining a best match from among multiple matches.

### B. Background of the Invention

An associative memory, such as a content addressable memory (CAM), is a device that permits the contents of the memory to be searched and matched instead of having to specify a memory location address in order to retrieve data from the memory. A CAM may be used to accelerate any application requiring fast searching of a database, list, or pattern, such as in database machines, image or voice recognition, or computer and communication networks. A CAM provides a performance advantage over conventional memory devices with conventional memory search algorithms, such as binary or tree-based searches, by comparing the desired information against the entire list of entries simultaneously, giving an order-of-magnitude reduction in search time. For example, a binary search through a database of 1000 entries may take ten separate search steps whereas a CAM device with 1000 entries may be searched in a single operation resulting in a search which takes ten times less time. One example of an application in which CAM devices are often used is to store a routing table for high speed switching systems which need to rapidly search the routing table to look for a matching destination address so that a data packet may be routed to the appropriate destination address.

A CAM device is organized somewhat differently from typical SRAM or DRAM devices. Information stored in a CAM may be accessed by comparing the data stored in the memory with data placed in a special register known as a search input or compare register as opposed to RAM devices in which information is accessed by specifying a particular memory address. If there is a match in particular memory locations with every corresponding bit in the register, a Match Flag is asserted to let the user know that the data in the register was found in the CAM device. Thus, with a CAM device, the user supplies a piece of data she would like to match to the CAM and gets back the address of any matching pieces of data in the CAM. There are two common types of CAM memory, binary CAM and ternary CAM. Binary cam requires an exact match of all bits in the search input and comparand for a match. Ternary CAM uses a mask to allow some bits to be treated as "don't care" bits and ignored in the determination of a match.

Data in a Binary CAM location typically comprises 2 fields: a comparand and an associated data field. Unlike a random access memory ("RAM"), when a search is performed on a CAM, all comparands in a CAM are compared simultaneously with a search input stored in a register. As each comparand is compared with the search input, a match line for that comparand is activated if the comparand matches the search word. Prior art ternary CAM devices may also contain an additional field known as a mask. The mask may be used to filter off portions of the comparand during the search procedure. In other words, the mask allows a comparison between the search input and only certain portions of the comparand as determined by the mask.

A search on a CAM may result in several matches in response to the search input, however, only one result should be returned. Therefore, one problem in the prior art is determining which match from a plurality of matches should be returned as the best match for a particular search input. One solution in the prior art is to implement a priority resolution circuit that uses the position of the data item in the CAM array to determine which match to output. One disadvantage in using a priority resolution circuit based on the position of the data item in the CAM array is that it only offers one criteria, (i.e. position) for determining a best match. Additionally, in order to change the priority of a particular CAM data item, it is necessary to move the data items to different positions in the CAM array. This process is cumbersome and slows down the operation of the CAM.Accordingly it is desirable to provide a priority resolution system that is capable of determining a best match among a plurality of CAM matches. More specifically, it is advantageous to provide a priority resolution system that can be dynamically updated and can use criteria other than position to determine a best match among a plurality of matches. Japanese Patent Application Publication number 11-102589 describes an Association Memory Module. The application aims to provide a association memory module having a high speed property being produced by performing best matching processing using hardware, and the flexibility for using the capacity of the entire prepared association memory module effectively. The memory module has a means capable of arbitrarily setting the order of priority of data selection in a priority encoder from the outside, and a simultaneous retrieval execution means for simultaneously giving input data to each of a plurality of association memories and for allowing each of a plurality of association memories to simultaneously execute retrieval. Then, the priority encoder selects one retrieval result from a plurality of retrieval results being obtained by simultaneously executing the retrieval.

WO 98/41922 discloses a content addressable memory that has a priority field to indicate a hierarchical level of addressing.

### SUMMARY OF THE INVENTION

According to a first aspect of the invention, there is provided a match resolution structure according to claim 1.

According to a second aspect of the invention, there is provided a method according to claim 15.

Embodiments of the present invention overcome the deficiencies and limitations of the prior art with a unique system and method for determining a best match from a plurality of matches resulting in response to a search input performed on an associative memory. The system and method for determining a best match from a plurality of matches comprises a priority field associated with each data item stored in the associative memory. The priority field corresponds to criteria that is used to order the priority of the data items. A match resolution module is coupled to receive match signals from an associative memory and the priority fields associated with the matching data entries. The match resolution structure compares the priority fields of the plurality of matching data items to determine which data item has the highest priority. The match resolution structure then indicates the data item having the highest priority as the best match of the associative memory for the particular search input.

These and other features and advantages of the present invention may be better understood by considering the following detailed description of preferred embodiments of the invention. In the course of this description, reference will be frequently made to the attached drawings.

### BRIEF DESCRIPTION OF THE DRAWINGS

Fig. 1 is a block diagram of one embodiment of a CAM including a priority field in accordance with the present invention.
Fig. 2 is a block diagram of one embodiment of a CAM including a match resolution circuit.
Fig. 3 is a block diagram of one embodiment of a method for determining a best match.
Fig. 4 is a block diagram illustrating one embodiment of a match resolution circuit for a CAM.
Fig. 5 is a block diagram of another embodiment of a match resolution circuit for a CAM.
Figs. 6a-6d are block diagrams of other embodiments of a match resolution circuit for a CAM.
Fig. 7 is one embodiment of a hierarchical match resolution circuit for a CAM.

### DETAILED DESCRIPTION OF PREFERRED EMBODIMENTS

The present invention is particularly applicable to a content addressable memory (CAM) device, such as that used as a single or dual port CAM memory, an event-co-processor, and a database co-processor, and it is in this context that the invention will be described. It will be appreciated, however, that the match resolution module in accordance with the invention has greater utility and may be used with any type of associative memory that accesses data based upon the content of the stored data (rather than the location in which that data is stored) and provides multiple matches in response to a search input.

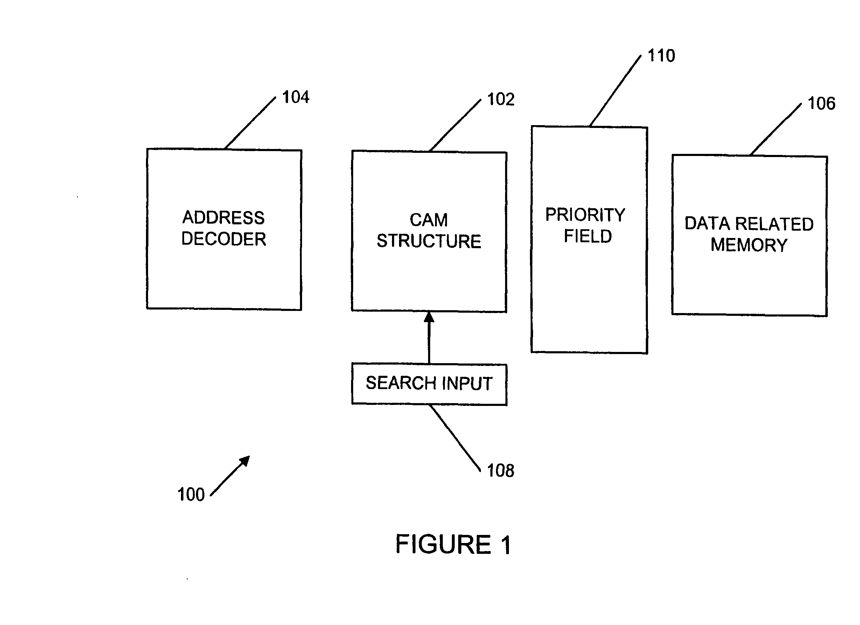

Referring now to Figure 1, there is shown one embodiment of a CAM having a match resolution circuit in accordance with the present invention. The CAM structure comprises a CAM match structure 102 for storing CAM words or data items, an address decoder 104 for addressing the CAM when initially storing data items, and a related memory 106 which may be a random access memory (RAM) or a read-only memory (ROM). Typical CAM usage involves locating a data item in the CAM match structure 102. A data item is specified by entering a search input 108 which compares simultaneously all of the data items stored in the CAM match structure 102 with the search input 108. A typical CAM search may result in finding a plurality of data items which match the search input 108. In order to determine a "best match" for the particular search input 108, a priority field 110 associated with each data item is evaluated to determine a best match from the plurality of matches. A best match can be determined by an arithmetic or logical comparison of the priority fields 110 of all matching CAM data items. When a best match is found for a particular search input 108, the apparatus can retrieve additional information concerning the requested data item from the related memory 106. As used herein, a "best match" is used to define a single data item from a plurality of data items that match the search input 108. As one skilled in the art will readily understand, a best match does not imply that there is only one true absolute match but that in the context of the priority field 110, there is one data item which will be considered to be a best match and will be outputted by the CAM. Examples of various best matches, priority fields, and criteria are discussed in more detail below.

As discussed above, the present invention provides a priority field 110 associated with each word of the CAM. The priority field 110 allows each data item to be prioritized according to some criteria. In a preferred embodiment, a priority field 110 comprises 16 bits. One skilled in the art will realize that the number of bits comprising the priority field 110 will depend on the number of bits required to uniquely identify the priority associated with a data item. The priority field 110 may correspond to any number of criteria, including but not limited to, a weight field stored in the CAM match structure 102, length of the longest contiguous unmasked field in the CAM match structure 102, the total number of unmasked bits in the CAM match structure 102, the total number of matching bits resulting from a compare, the path length metric derived from a routing protocol such as OSPF, the order of an order dependent list such as an Access Control List for a router, or position in the CAM match structure. Thus, the present invention advantageously allows the use of a variety of criteria for ordering the priority of each data item.

Additionally, because the priority field is a separate field for indicating the priority of the data item, the priority of the various data items may be changed by changing the entry in the priority field. For example, assume a CAM structure contains a first data item A, a second data item B, and a third data item C. Further assume that the first data item A has a priority field indicating that it has a priority of 1, the second data item B has a priority field indicating that it has a priority of 2, and the third data item C has a priority field indicating that it has a priority of 3. If priority is determined according to the priority field with the highest number, then the third data item C, which has a priority of 3, has the highest priority. However, if for some reason it is necessary to change the priority of the data items, the priority of a data item may be changed simply by changing the priority field. For example, assume that the priority field for the first data item A is changed from 1 to 3 and the priority field for the third data item C is changed from 3 to 1, then using the same convention that priority is determined according to the highest number, the first data item A, which now has a new priority of 3, has the highest priority. Thus, the present invention advantageously provides a simple mechanism for changing the priority of data items by changing the priority in the priority field.

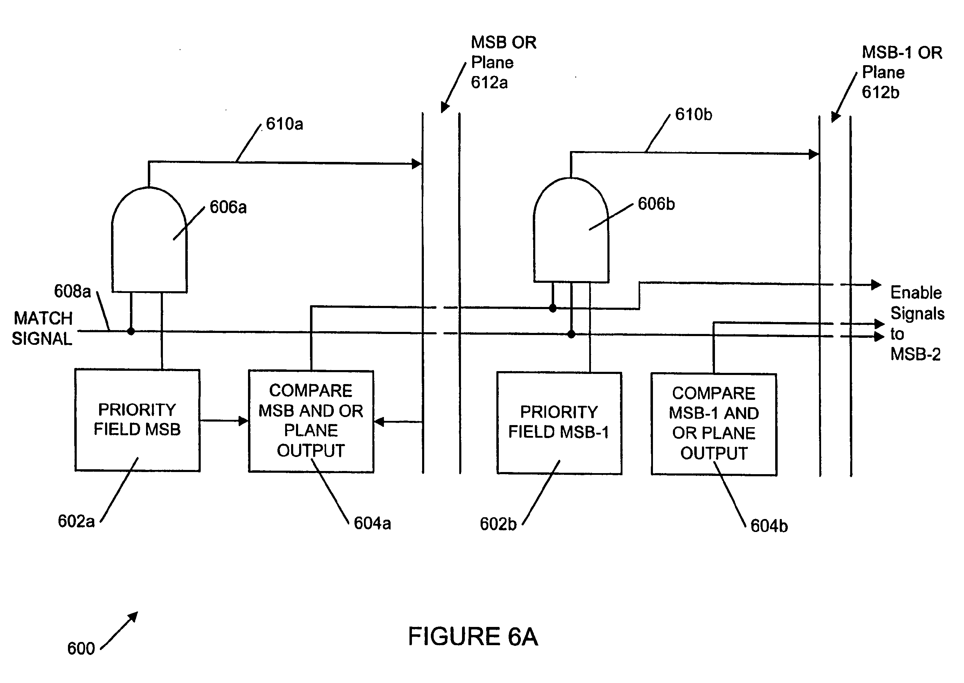

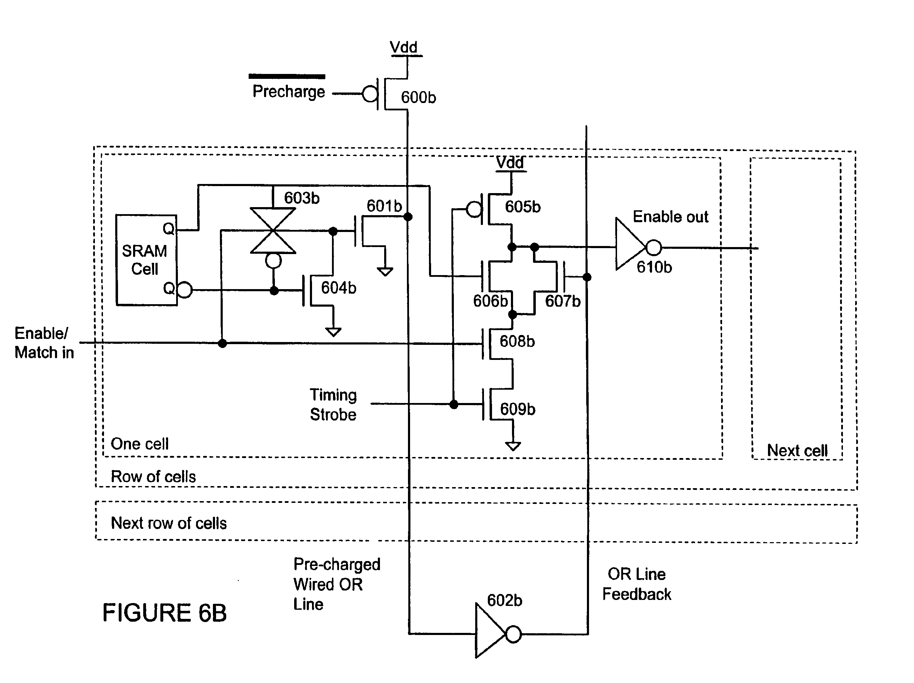

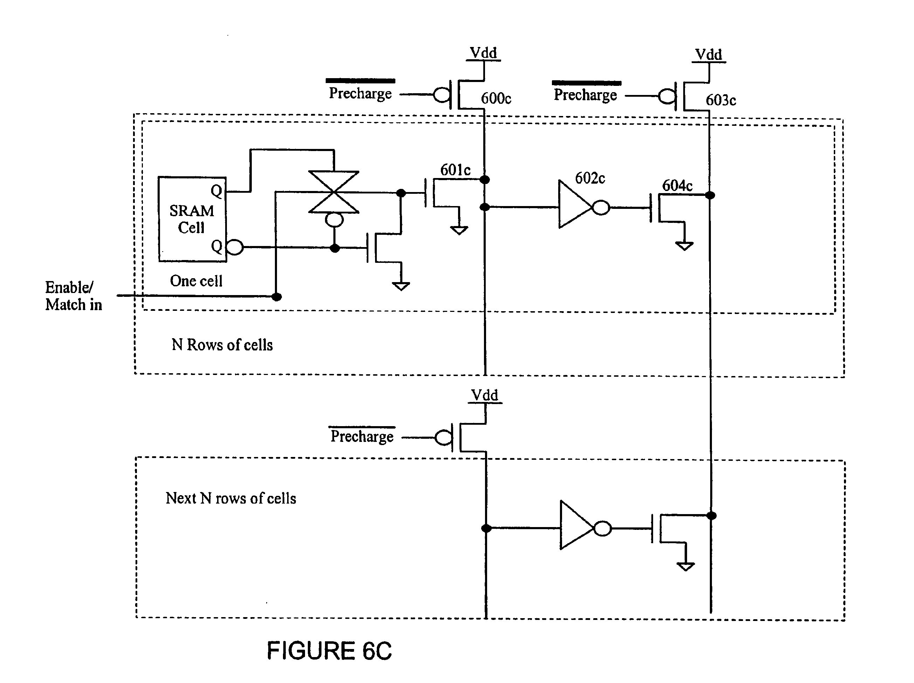

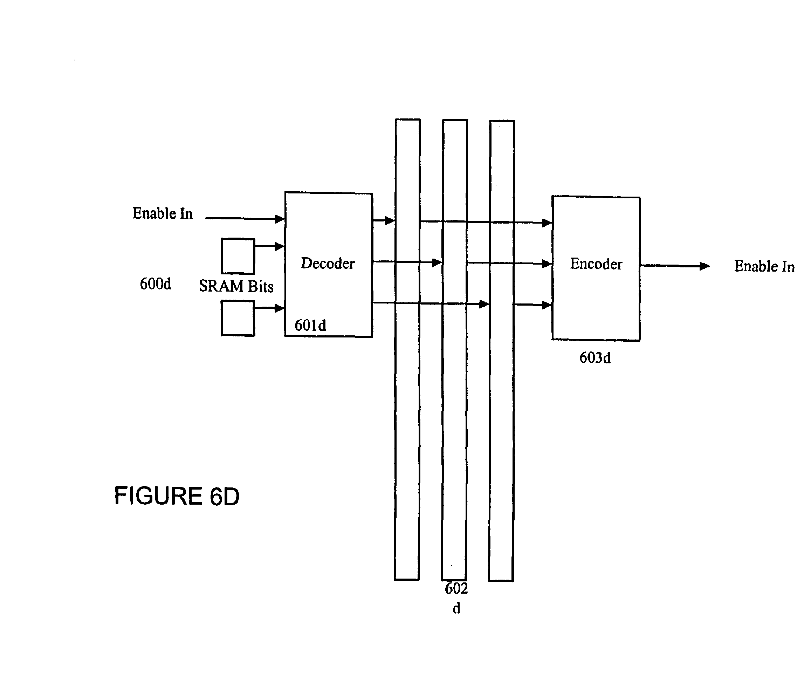

The present invention also provides for hierarchical match resolution. In other words, if two or more CAM data items have the same priority according to one priority field criteria, then a second priority field criteria can be applied to these entries to determine a best match. A preferred embodiment for a hierarchical match resolution system for a CAM is described below in more detail with reference to Figure 6.

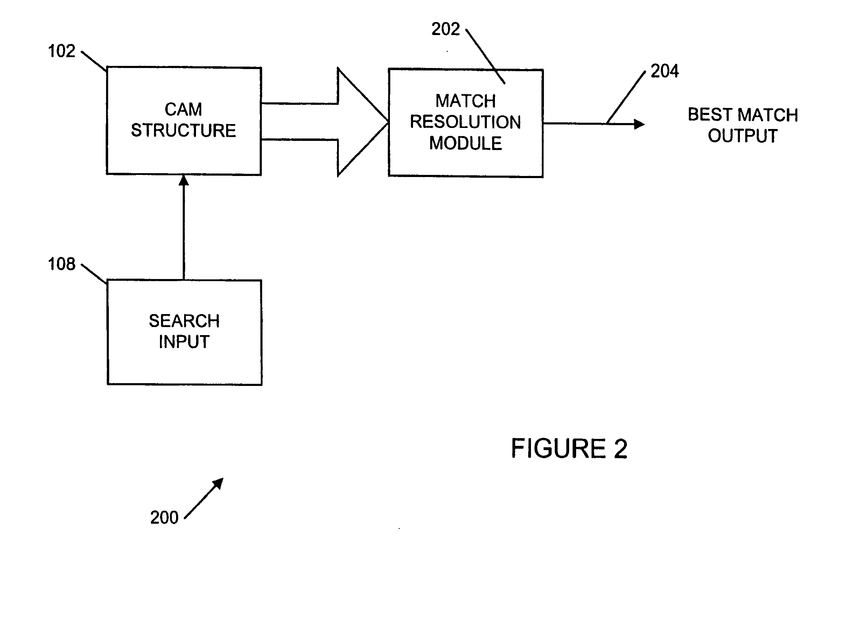

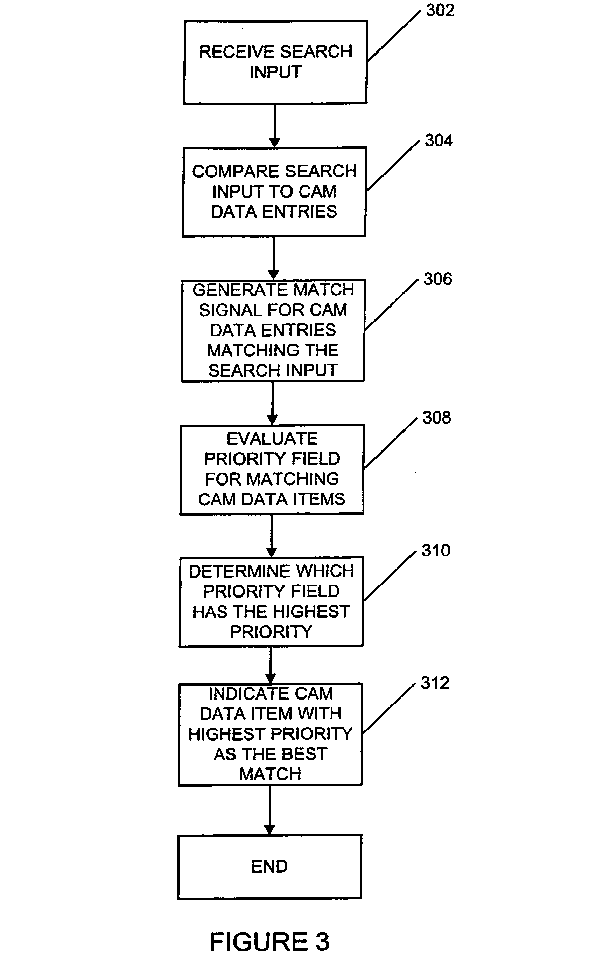

Referring now to Figure 2 and Figure 3, there are shown a functional block diagram of one embodiment of a CAM including a match resolution circuit and a block diagram of one embodiment of a method for determining a best match from a plurality of matches. The CAM structure 200 comprises a CAM structure 102 coupled to receive a search input 108. The CAM structure 102 receives (302) the search input 108 and compares (304) the search input 108 to all the data item entries in the CAM structure 102 as described above. The CAM structure 102 then generates (306) a match signal (not shown) for all CAM data items in the CAM that match the search input 108. The CAM structure 102 then outputs the match signal and the priority field (not shown) to the match resolution circuit 202. The match resolution circuit 202 evaluates (308) the priority field for each matching CAM data item and determines (310) which priority field has the highest priority. The output of the match resolution circuit 202 then indicates (312) the CAM data item with the highest priority according to the priority field. The indicated item is considered the best match for the particular search input 108. Preferably, the output of the match resolution circuit 204 comprises either prioritized match signals or the address of the highest priority matching entry.

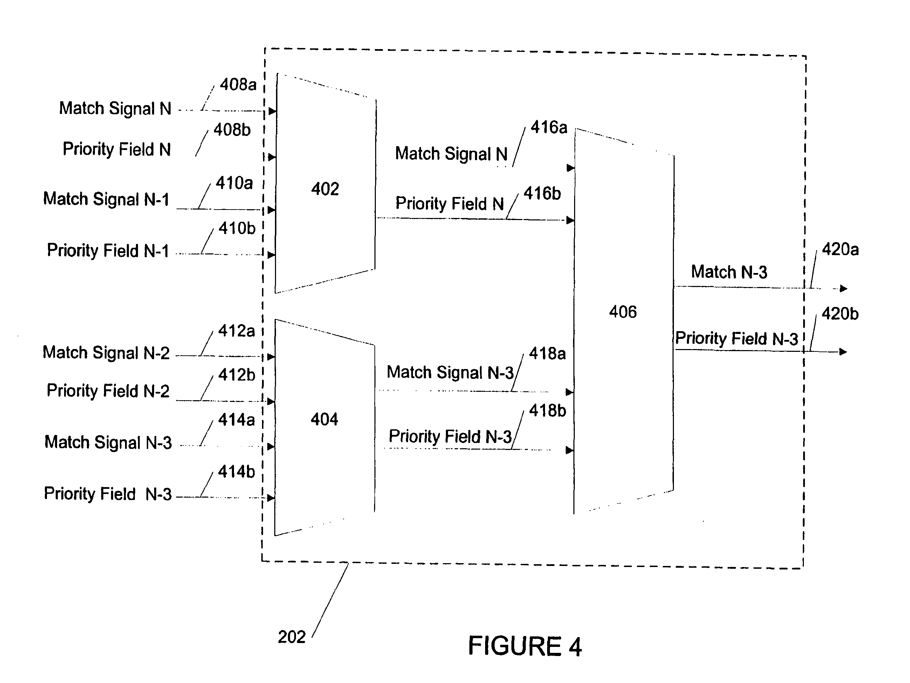

Referring now to Figure 4, there is shown a block diagram illustrating one embodiment of a CAM match resolution circuit. A CAM match resolution circuit in accordance with the present invention comprises a first two port priority resolution circuit 402, a second two port priority resolution circuit 404, and a third two port priority resolution circuit 406. The first and second two port priority resolution circuits, 402 and 404, are each coupled to receive a match signal and a priority field associated with two CAM data items. For example, the first two port priority resolution circuit 402 is coupled to receive a first match signal 408a and a first priority field signal 408b from one CAM data item, and a second match signal 410a and a second priority field signal 408b from a second CAM data time. The first two port priority resolution circuit 402 determines which CAM data item has the higher priority according to the inputted match and priority field signals and outputs the match signal 416a and the priority field signal 416b with the highest priority. Similarly, the second two port priority resolution circuit 404 is coupled to receive a first match signal 412a and a first priority field signal 412b from one CAM data item, and a second match signal 414a and a second priority field signal 414b from a second CAM data item. The second two port priority resolution circuit 404 determines which CAM data item has the higher priority according to the inputted match and priority field signals and outputs the match signal 418a and the priority field signal 418b with the highest priority. The third two port priority resolution circuit 406 then compares the results from two port priority resolution circuit 402 and two port priority resolution circuit 404 and outputs the match signal 420a and the priority field signal 420b with the highest priority. For example, if the priority field signal corresponds to an assigned priority number, then the CAM data item with the highest priority number would be outputted from two port priority resolution circuit 406. One skilled in the art will recognize that the present invention is not limited to only determining the "highest priority" but that the principles of the present invention can also be used to determine and output the data item with the "lowest" priority. Thus, a CAM match resolution circuit can be implemented as a stack of two entry match resolution circuits wherein each two entry match resolution circuit compares two input values and outputs the greater value. The present invention is not limited to the use of three two port priority resolution circuit in a two stage circuit for determining a best match, but one skilled in the art will realize that the principles of the present invention may be applied to any number of two port priority resolution circuit arranged in the necessary number of stages for comparing the priority fields of any number of data items..

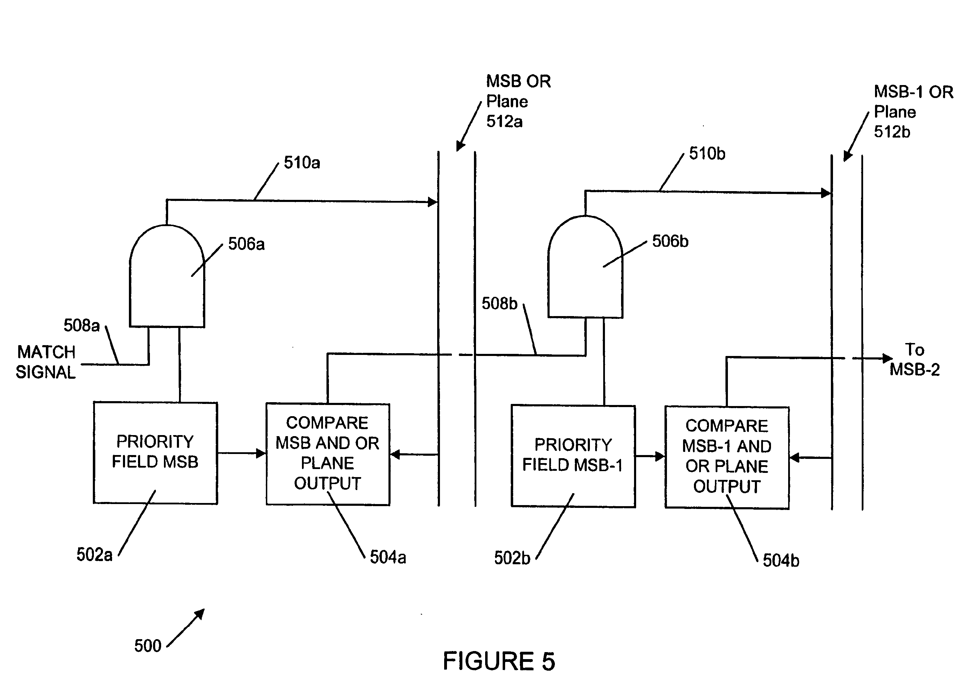

Referring now to Figure 5, there is shown a block diagram of one embodiment of one row of a match resolution circuit for a CAM. The match resolution circuit 500 comprises a priority field Most Significant Bit (MSB) component 502, a compare MSB and OR plane output component 504, a match signal 508, an AND gate 506, and a MSB OR plane 512. As indicated in Figure 5, the match resolution circuit of the present invention incorporates each of these elements for each bit in the priority field. In other words, the bits in the priority field for a data item are evaluated serially. Figure 5 illustrates these elements for only two bits of the priority field in the interest of simplicity. In a preferred embodiment, the match signal 508 is the high order bit of the priority field. For the first bit in the priority field, the match signal 508a and the priority field MSB are ANDed together and outputted to the MSB OR plane 512a. The result of the MSB OR plane 512a is compared with the MSB of the priority field received from the priority field MSB 502a. The result is then used as compare ok or enable signal for the next AND gate 506b for the next comparison. This process is repeated until a determination of the best match is made. Thus, the most significant bit of all priority fields are compared to the result of the OR plane. If the priority field bit matches the result a compare OK signal is propagated to the next less significant bit. The OR function can also be implemented using pre-charge logic as shown in figure 6b.

Referring now to Figure 6a, there is shown another embodiment of a match resolution circuit for a CAM in accordance with the present invention. The embodiment described in detail in Figure 5 can be implemented using a "look ahead" logic similar to an adder circuit. The addition of a "look ahead" logic advantageously improves the speed of the match resolution circuit. In another embodiment, the MSB OR plane 512 can be implemented using wide gate structures as described in U.S. Patent No. 5,999,435, entitled "Content Addressable Memory Device," by Alex E. Henderson and Walter E. Croft.

Figure 6b is a precharge logic implementation of the circuit of figure 6a. The OR function is implemented by pre-charge transistor 600b, pulldown transistor 601 b (one per cell) and inverter 602b. Transfer gate 603b and transistor 604b implement the AND function. The compare function is implemented by the pre-charge logic complex gate comprising transistors 605b through 609b and inverter 610b. Transistors 605b and 609b are controlled by a timing signal generated by a dummy row or other timing method. The timing strobe is required to prevent a false enable out from corrupting the result of the next cell. The timing circuits are designed so that the timing strobe occurs after the OR feedback line is stable.

Figure 6c is a faster version of the circuit of figure 6b. The pre-charge logic OR has been divided into multiple sub-circuits comprising N rows (transistors 600c, 601c and inverter 602c). The results of the sub-circuits are combined by a second OR circuit comprising transistors 603c and 604c. This reduces the loading on the first layer OR resulting in increased speed and combines the feedback and second level OR function.

Figure 6d is a diagram of a match resolution circuit that implements a multi-bit priority resolution to further increase speed. Multiple priority bits are decoded and used to drive multiple OR planes. The results of the OR functions are encoded to generate an enable output. The pre-charge implementations of the OR functions described in 6b and 6c can be used to implement the OR planes. For a two bit priority resolution circuit the decodes x1, 1x and 11 can be used as inputs to the OR planes.

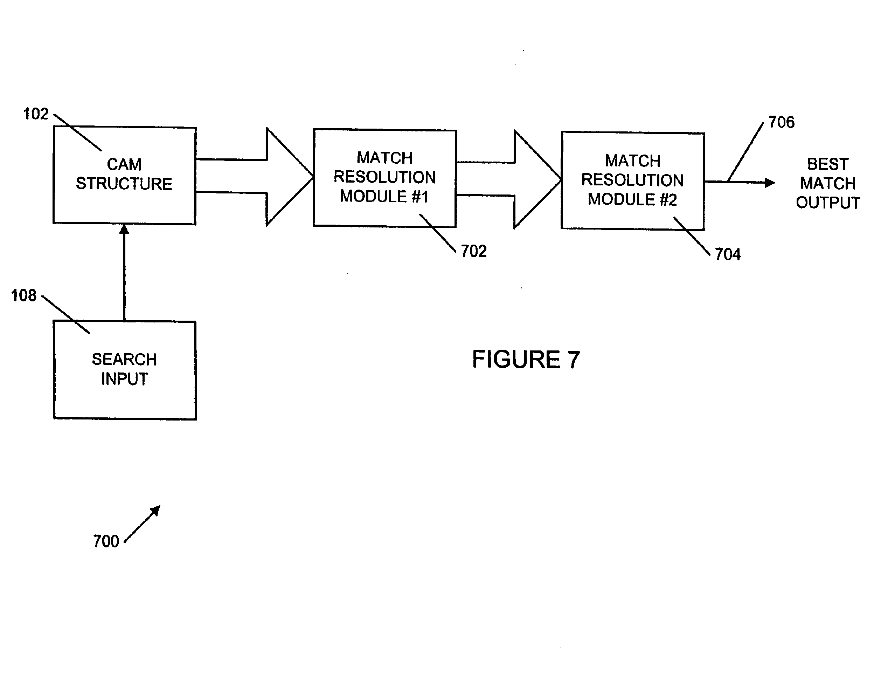

Referring now to Figure 7, there is shown one embodiment of hierarchical match resolution circuit for a CAM. The hierarchical match resolution circuit for CAM cascades two or more match resolution circuits, 702 and 704, such that if there are multiple "best" matches based on a first criteria (e.g. network path length), a second criteria (e.g. link speed) can be used to determine the best match. A hierarchical match resolution circuit for a CAM comprises a CAM structure 102 coupled to receive an input search 108, a first match resolution module 702, and a second match resolution module 704. As described above, the CAM structure 102 receives a search input 108 and compares the search input 108 to all the CAM data items. The CAM structure 102 then generates a match signal for each data item which matches the search input 108. The search result of the CAM may result in a plurality of data items which match the search input 108. In such instances, a first match resolution circuit 702 is coupled to receive the match signals and the first priority fields associated with each CAM data item that matched the search input 108. The first match resolution circuit 702 evaluates the first priority field of each of the matching items and determines which data item has the highest priority based on the first priority fields. The first match resolution circuit 702 may result in multiple data items having equal priority based on the first priority field (e.g. when network path length is used). The second priority fields are then evaluated to determine a best match best on the second priority field with the highest priority. The data item with the second priority field with the highest priority is then outputted as the best match. One skilled in the art will recognize that the present invention is not limited to two match resolution circuits but that any number of match resolution circuits may be implemented to determine a best match using several criteria. Additionally, for each additional criteria used for determining priority, an additional priority field is associated with each data item. Thus, if two criteria are used for determining priority in a hierarchical match resolution circuit, then preferably each data item includes a first priority field and a second priority field. Similarly, if three criteria are used for determining priority in a hierarchical match resolution circuit, then preferably each data item includes a first priority field, a second priority field, and a third priority field. Thus, the present invention advantageously allows more than one criteria to be used to determine a best match from a plurality of matches resulting from a CAM search.

From the above description, it will be apparent that the invention disclosed herein provides a novel and advantageous system and method for determining a best match from a plurality of matches determined in response to a search item. The foregoing discussion discloses and describes merely exemplary methods and embodiments of the present invention. As will be understood by those familiar with the art, the invention may be embodied in other specific forms

Accordingly, the disclosure of the present invention is intended to be illustrative, but not limiting, of the scope of the invention, which is set forth in the following claims.

## Claims

1. A match resolution structure selecting a best matching data item from a plurality of matching data items, the plurality of matching data items determined in response to a search input (108) performed on an associative memory, the structure comprising:
a plurality of match inputs, each match input receiving a priority field (110) indicating a priority of the match input; and the structure being **characterised by** further comprising:
a match resolution logic, coupled to receive the priority field from at least two match inputs, comparing the priority fields (110) and indicating a best matching data item;
and wherein said priority field allows each of said plurality of matching data items to be prioritised according to more than one criteria.

2. The structure of claim 1 wherein the priority field (110) contains the prefix length of an IP address.

3. The structure of claim 1 wherein the priority field (110) contains a path length metric derived from a routing protocol such as OSPF.

4. The structure of claim 1 wherein the priority field (110) contains the order of an order dependent list such as an Access Control List for a router.

5. The structure of claim 1 wherein the priority field (110) for a data item may be changed to indicate a change in priority for that data item.

6. The structure of claim 1 wherein the match resolution logic comprises a stack of two port priority resolution circuits.

7. The structure of claim 1 further comprising a second priority field associated with each data item.

8. The structure of claim 1 wherein the priority field contains the length of the longest contiguous unmasked field in the data item.

9. The structure of claim 1 wherein the priority field contains the total number of unmasked bits in the data entry.

10. The match resolution structure of any preceding claim, wherein:
the plurality of matching data items comprises at least a first data item and a second data item, the first data item including a first priority field and the second data item including a first priority field;
the plurality of match inputs comprises a first input for receiving the first priority field of the first data item and a second input for receiving the first priority field of the second data item; and
the match resolution logic compares the first priority field of the first data item and the first priority field of the second data item, and indicates the first priority field with the highest priority.

11. The structure of claim 10 wherein at least one of the first and second priority fields contains the length of the longest contiguous unmasked field in the data item.

12. The structure of claim 10 wherein the first and second priority field contain the total number of unmasked bits in the data item.

13. The structure of claim 10 wherein:
the first data item and the second data item each further include a second priority field;
the plurality of match inputs further comprises a third input for receiving the second priority field of the first data item, and a fourth input for receiving the second priority field of the second data item; and
the match resolution logic further compares the second priority field of the first data item and the second priority field of the second data item, and indicates the second priority field with the highest priority.

14. The structure of any preceding claim wherein the associative memory is a CAM.

15. A method for selecting a best matching data item from a plurality of matching data items determined in response to a search input (108) performed on an associative memory, each matching data item having a priority field (110), the method comprising:
receiving the priority field for each matching data item;
evaluating (308) the priority field for each matching data item; and the method being **characterised by** further comprising:
comparing the priority fields for the data items to determine (310) a best matching data item,
and wherein said priority field allows each of said plurality of matching data items to be prioritised according to more than one criteria.

16. The method of claim 15 wherein the priority field contains the length of the longest contiguous unmasked field in the data item.

17. The method of claim 15 wherein the priority field contains the total number of unmasked bits in the data entry.

18. The method of claim 15 further comprising the step of:
altering the priority of at least one data item by changing the priority field of at least one data item.

19. The method of claim 15 wherein the priority field contains the length of the longest contiguous unmasked field in the data item.

20. The method of claim 15 wherein the priority field contains the position of data item.

21. The method of claim 15 wherein the data item further includes a second priority field, the method further comprising the step of:
comparing the second priority fields associated with the data items to determine a best matching data item.

22. The method of claim 15 wherein the associative memory is a CAM.

## Patentansprüche

1. Übereinstimmungsauflösungsstruktur, die ein am besten übereinstimmendes Datenelement aus mehreren übereinstimmenden Datenelementen auswählt, wobei die mehreren übereinstimmenden Datenelemente in Reaktion auf einen Sucheingang (108) bestimmt werden, angewendet auf einen Assoziativspeicher, wobei die Struktur umfasst:
mehrere Übereinstimmungseingänge, wobei jeder Übereinstimmungseingang ein Prioritätsfeld (110) aufnimmt, das eine Priorität des Übereinstimmungseingangs angibt; und wobei die Struktur **dadurch gekennzeichnet ist, dass** sie ferner umfasst:
eine Übereinstimmungsauflösungslogik, verbunden zum Aufnehmen des Prioritätsfeldes von wenigstens zwei Übereinstimmungseingängen, Vergleichen der Prioritätsfelder (110) und Anzeigen eines am besten übereinstimmenden Datenelements;
und wobei das Prioritätsfeld jedem der mehreren übereinstimmenden Datenelemente erlaubt, gemäß mehr als einem Kriterium priorisiert zu werden.

2. Struktur nach Anspruch 1, wobei das Prioritätsfeld (110) die Vorspannlänge einer IP-Adresse enthält.

3. Struktur nach Anspruch 1, wobei das Prioritätsfeld (110) eine Pfadlängenmetrik enthält, die aus einem Routing-Protokoll, wie z. B. OSPF, abgeleitet ist.

4. Struktur nach Anspruch 1, wobei das Prioritätsfeld (110) die Anordnung einer anordnungsabhängigen Liste, wie z. B. einer Zugangskontrollliste für einen Router, enthält.

5. Struktur nach Anspruch 1, wobei das Prioritätsfeld (110) für ein Datenelement verändert werden kann, um eine Änderung der Priorität für dieses Datenelement anzuzeigen.

6. Struktur nach Anspruch 1, wobei die Übereinstimmungsauflösungslogik einen Stapel von Zwei-Anschluss-Prioritätsauflösungsschaltungen umfasst.

7. Struktur nach Anspruch 1, die ferner ein zweites Prioritätsfeld umfasst, das jedem Datenelement zugeordnet ist.

8. Struktur nach Anspruch 1, wobei das Prioritätsfeld die Länge des längsten zusammenhängenden unmaskierten Feldes im Datenelement enthält.

9. Struktur nach Anspruch 1, wobei das Prioritätsfeld die Gesamtzahl der unmaskierten Bits im Dateneintrag enthält.

10. Übereinstimmungsauflösungsstruktur nach irgendeinem der vorangehenden Ansprüche, wobei:
die mehreren übereinstimmenden Datenelemente wenigstens ein erstes Datenelement und ein zweites Datenelement umfassen, wobei das erste Datenelement ein erstes Prioritätsfeld enthält und das zweite Datenelement ein erstes Prioritätsfeld enthält;
die mehreren Übereinstimmungseingänge einen ersten Eingang zum Aufnehmen des ersten Prioritätsfeldes des ersten Datenelements und einen zweiten Eingang zum Aufnehmen des ersten Prioritätsfeldes des zweiten Datenelements umfassen; und
die Übereinstimmungsauflösungslogik das erste Prioritätsfeld des ersten Datenelements und das erste Prioritätsfeld des zweiten Datenelements vergleicht und das erste Prioritätsfeld mit der höchsten Priorität anzeigt.

11. Struktur nach Anspruch 10, wobei wenigstens eines der ersten und zweiten Prioritätsfelder die Länge des längsten zusammenhängenden unmaskierten Feldes im Datenelement enthält.

12. Struktur nach Anspruch 10, wobei das erste und das zweite Prioritätsfeld die Gesamtzahl der unmaskierten Bits im Datenelement enthalten.

13. Struktur nach Anspruch 10, wobei:
das erste Datenelement und das zweite Datenelement jeweils ferner ein zweites Prioritätsfeld enthalten;
die mehreren Übereinstimmungseingänge ferner einen dritten Eingang zum Aufnehmen des zweiten Prioritätsfeldes des ersten Datenelements und einen vierten Eingang zum Aufnehmen des zweiten Prioritätsfeldes des zweiten Datenelements umfassen; und
die Übereinstimmungsauflösungslogik ferner das zweite Prioritätsfeld des ersten Datenelements und das zweite Prioritätsfeld des zweiten Datenelements vergleicht und das zweite Prioritätsfeld mit der höchsten Priorität anzeigt.

14. Struktur nach irgendeinem der vorangehenden Ansprüche, wobei der Assoziativspeicher ein CAM ist.

15. Verfahren zum Auswählen eines am besten übereinstimmenden Datenelements aus mehreren übereinstimmenden Datenelementen, die bestimmt werden in Reaktion auf einen Sucheingang (108), angewendet auf einen Assoziativspeicher, wobei jedes übereinstimmende Datenelement ein Prioritätsfeld (110) aufweist, und wobei das Verfahren umfasst:
Aufnehmen des Prioritätsfeldes für jedes übereinstimmende Datenelement;
Bewerten (308) des Prioritätsfeldes für jedes übereinstimmende Datenelement; wobei das Verfahren **dadurch gekennzeichnet ist, dass** es ferner umfasst:
Vergleichen der Prioritätsfelder für die Datenelemente, um ein am besten übereinstimmendes Datenelement zu bestimmen (310),
und wobei das Prioritätsfeld jedem der mehreren übereinstimmenden Datenelemente erlaubt, gemäß mehr als einem Kriterium priorisiert zu werden.

16. Verfahren nach Anspruch 15, wobei das Prioritätsfeld die Länge des längsten zusammenhängenden unmaskierten Feldes im Datenelement enthält.

17. Verfahren nach Anspruch 15, wobei das Prioritätsfeld die Gesamtzahl der unmaskierten Bits im Dateneintrag enthält.

18. Verfahren nach Anspruch 15, das ferner den Schritt umfasst:
Ändern der Priorität wenigstens eines Datenelements durch Ändern des Prioritätsfeldes des wenigstens einen Datenelements.

19. Verfahren nach Anspruch 15, wobei das Prioritätsfeld die Länge des längsten zusammenhängenden unmaskierten Feldes im Datenelement enthält.

20. Verfahren nach Anspruch 15, wobei das Prioritätsfeld die Position des Datenelements enthält.

21. Verfahren nach Anspruch 15, wobei das Datenelement ferner ein zweites Prioritätsfeld enthält, und wobei das Verfahren ferner den Schritt umfasst:
Vergleichen der zweiten Prioritätsfelder, die den Datenelementen zugeordnet sind, um ein am besten übereinstimmendes Datenelement zu bestimmen.

22. Verfahren nach Anspruch 15, wobei der Assoziativspeicher ein CAM ist.

## Revendications

1. Structure de résolution de correspondance sélectionnant un élément de données correspondant le mieux parmi une pluralité d'éléments de données correspondants, la pluralité d'éléments de données correspondants étant déterminée en réponse à une entrée de recherche (108) effectuée sur une mémoire associative, la structure comprenant :
une pluralité d'entrées de correspondance, chaque entrée de correspondance recevant un champ de priorité (110) indiquant une priorité de l'entrée de correspondance ; et la structure étant **caractérisée par le fait qu'**elle comprend en outre :
une logique de résolution de correspondance, reliée de façon à recevoir le champ de priorité d'au moins deux entrées de correspondance, comparant les champs de priorité (110) et indiquant un élément de données correspondant le mieux ;
et dans laquelle ledit champ de priorité permet de classer par priorité chacun de ladite pluralité d'éléments de données correspondants en fonction de plus d'un critère.

2. Structure selon la revendication 1, dans laquelle le champ de priorité (110) contient la longueur de préfixe d'une adresse IP (pour "Internet Protocol" - Protocole Internet).

3. Structure selon la revendication 1, dans laquelle le champ de priorité (110) contient une métrique de longueur de trajet dérivant d'un protocole de routage tel que le protocole OSPF (pour "Open Shortest Path First" - Trajet Ouvert le Plus Court en Premier).

4. Structure selon la revendication 1, dans laquelle le champ de priorité (110) contient l'ordre et une liste dépendant de l'ordre telle qu'une Liste de Contrôle d'Accès pour un routeur.

5. Structure selon la revendication 1, dans laquelle le champ de priorité (110) destiné à un élément de données peut être modifié pour indiquer un changement de priorité pour cet élément de données.

6. Structure selon la revendication 1, dans laquelle la logique de résolution de correspondance comprend une pile de circuits de résolution de priorité à deux accès.

7. Structure selon la revendication 1, comprenant en outre un deuxième champ de priorité associé à chaque élément de données.

8. Structure selon la revendication 1, dans laquelle le champ de priorité contient la longueur du champ non masqué contigu le plus long dans l'élément de données.

9. Structure selon la revendication 1, dans laquelle le champ de priorité contient le nombre total de bits non masqués dans l'entrée de données.

10. Structure de résolution de correspondance selon l'une quelconque des revendications précédentes, dans laquelle :
la pluralité d'éléments de données correspondants comprend au moins un premier élément de données et un deuxième élément de données, le premier élément de données comprenant un premier champ de priorité et le deuxième élément de données comprenant un premier champ de priorité ;
la pluralité d'entrées de correspondance comprend une première entrée pour recevoir le premier champ de priorité du premier élément de données et une deuxième entrée pour recevoir le premier champ de priorité du deuxième élément de données ; et
la logique de résolution de correspondance compare le premier champ de priorité du premier élément de données et le premier champ de priorité du deuxième élément de données, et indique le premier champ de priorité ayant la priorité la plus haute.

11. Structure selon la revendication 10, dans laquelle au moins l'un des premier et deuxième champs de priorité contient la longueur du champ non masqué contigu le plus long dans l'élément de données.

12. Structure selon la revendication 10, dans laquelle les premier et deuxième champs de priorité contiennent le nombre total de bits non masqués dans l'élément de données.

13. Structure selon la revendication 10, dans laquelle:
le premier élément de données et le deuxième élément de données comprennent en outre chacun un deuxième champ de priorité ;
la pluralité d'entrées de correspondance comprend en outre une troisième entrée pour recevoir le deuxième champ de priorité du premier élément de données et une quatrième entrée pour recevoir le deuxième champ de priorité du deuxième élément de données ; et
la logique de résolution de correspondance compare en outre le deuxième champ de priorité du premier élément de données et le deuxième champ de priorité du deuxième élément de données et indique le deuxième champ de priorité ayant la priorité la plus haute.

14. Structure selon l'une quelconque des revendications précédentes, dans laquelle la mémoire associative est une mémoire CAM (pour "Content Addressable Memory" - Mémoire Adressable par Contenu).

15. Procédé pour sélectionner un élément de données correspondant le mieux parmi une pluralité d'éléments de données correspondants déterminés en réponse à une entrée de recherche (108) effectuée sur une mémoire associative, chaque élément de données correspondant ayant un champ de priorité (110), le procédé consistant à :
recevoir le champ de priorité pour chaque élément de données correspondant ;
évaluer (308) le champ de priorité pour chaque élément de données correspondant ; le procédé étant **caractérisé par le fait qu'**il consiste en outre à :
comparer les champs de priorité des éléments de données pour déterminer (310) un élément de données correspondant le mieux,
et dans lequel ledit champ de priorité permet de classer par priorité chacun de ladite pluralité d'éléments de données correspondants en fonction de plus d'un critère.

16. Procédé selon la revendication 15, dans lequel le champ de priorité contient la longueur du champ non masqué contigu le plus long dans l'élément de données.

17. Procédé selon la revendication 15, dans lequel le champ de priorité contient le nombre total de bits non masqués dans l'entrée de données.

18. Procédé selon la revendication 15, comprenant en outre l'étape consistant à :
modifier la priorité d'au moins un élément de données en changeant le champ de priorité d'au moins un élément de données.

19. Procédé selon la revendication 15, dans lequel le champ de priorité contient la longueur du champ non masqué contigu le plus long dans l'élément de données.

20. Procédé selon la revendication 15, dans lequel le champ de priorité contient la position de l'élément de données.

21. Procédé selon la revendication 15, dans lequel l'élément de données comprend en outre un deuxième champ de priorité, le procédé comprenant en outre l'étape consistant à :
comparer les deuxièmes champs de priorité associés aux éléments de données pour déterminer un élément de données correspondant le mieux.

22. Procédé selon la revendication 15, dans lequel la mémoire associative est une mémoire CAM.
